Europäisches Patentamt

European Patent Office

Office européen des brevets

(11) Veröffentlichungsnummer: **0 232 748**
A1

# (12) EUROPÄISCHE PATENTANMELDUNG

(21) Anmeldenummer: 87100617.7

(22) Anmeldetag: 19.01.87

(51) Int. Cl.4: **H01L 21/76** , H01L 21/316

(30) Priorität: 22.01.86 DE 3601855

(43) Veröffentlichungstag der Anmeldung:
19.08.87 Patentblatt 87/34

(84) Benannte Vertragsstaaten:
AT CH DE FR GB IT LI NL SE

(71) Anmelder: **Siemens Aktiengesellschaft Berlin und München**
**Wittelsbacherplatz 2**
**D-8000 München 2(DE)**

(72) Erfinder: **Becker, Frank Stefan, Dr.**
**Neufriedenheimer Strasse 67a**
**D-8000 München 70(DE)**
Erfinder: **Röhl, Siegfried, Dr.**
**Oberbrandweg 12**
**D-8029 Sauerlach(DE)**

(54) **Verfahren zur Auffüllung von Isolationsgräben in integrierten Halbleiterschaltungen.**

(57) Bei einem Verfahren zur Auffüllung von in Siliziumsubstrate (3) zum Zwecke der Isolation der aktiven Bauelemente einer integrierten Schaltung eingebrachte Gräben (1) wird ein Bor-Phosphor-Silikatglas (2) verwendet, welches durch gleichzeitige thermische Zersetzung von Tetraethylorthosilikat, Trimethylborat und Phosphin oder Trimethylphosphat bei 600 bis 700°C in einem Niederdruckreaktor hergestellt worden ist. Durch die Verwendung dieses speziellen Isolationsmaterials (2) bei der Grabenisolationstechnik können enge (1 μm) und tiefe (4 μm) Gräben (1) im μm-und sub μm-Bereich ohne Hohlräume aufgefüllt werden. Das Verfahren wird angewandt bei der Herstellung von hochintegrierten MOS-und Bipolarschaltungen.

FIG 2.

EP 0 232 748 A1

## Verfahren zur Auffüllung von Isolationsgräben in integrierten Halbleiterschaltungen.

Die Erfindung betrifft ein Verfahren zur Auffüllung von in Siliziumsubstrate zum Zwecke der Isolation der aktiven Bauelemente einer integrierten Schaltung eingebrachten Gräben mit im wesentlichen aus $SiO_2$ bestehendem Isolationsmaterial.

Die zunehmende Strukturverkleinerung in MOS-und Bipolarschaltungen benötigt neue Isolationstechniken, da eine weitere Reduktion der herkömmlichen LOCOS-Isolationstechnik, wie sie beispielsweise in Philips Res. Reports 25, Seiten 118 -132, 1976, beschrieben ist, an der Länge des aus $SiO_2$ bestehenden, als Vogelschnabel ausgebildeten Feldoxids scheitert. Außerdem verursacht die selektive Oxidation Spannungen im Substrateinkristall, welche die elektrischen Eigenschaften der Schaltungen stark beeinflussen. Ein weiteres Hindernis zur Strukturverkleinerung ist die laterale Ausdiffusion der Kanalstopper-Implantation durch die hohe Temperaturbelastung beim LOCOS-Prozeß.

Eine Grabenisolationstechnik, wie sie beispielsweise in der europäischen Patentanmeldung Nr. 0 044 082 A2 beschrieben ist, ist geeignet, die genannten Probleme zu lösen. Bei dieser Technik ist die Herstellung von Gräben von 1 μm Breite und 0,5 bis 1 μm Tiefe zur Isolation von MOS-Transistoren möglich.

Bei der Isolation von Transistoren unterschiedlichen Leitungstyps in CMOS-Schaltungen erreicht man mit tieferen Gräben, wie zum Beispiel 4 μm Tiefe und 1 μm Breite, wesentliche Flächenreduktionen. Das Gleiche ist bei Bipolarschaltungen der Fall, da hier mit tiefen Gräben die vergrabenen Dotierschichten gegeneinander isoliert werden können. Die Verwirklichung dieser Fortschritte in der Isolationstechnik setzt die Möglichkeit zur Herstellung tiefer, mit einem isolierenden Material gefüllter Gräben voraus.

Zur Auffüllung von Gräben mit einem Aspektverhältnis von Tiefe zu Breite größer 1 sind bisher verschiedene Verfahren vorgeschlagen oder eingesetzt worden, die sich jedoch durch unterschiedliche Nachteile auszeichnen. Allen Verfahren, die auf einer Auffüllung des Grabens mit einer durch chemical vapor depositon (CVD = Abscheidung aus der Gasphase) hergestellten Substanz beruhen (siehe Internationales Patent WO 81/03241, Europäische Patentanmeldung Nr. 0 000 897 A1, ECS Fall Meeting, Ext. Abstr. No. 311, Vol. 83-2, 10.83, Seiten 490 bis 491), ist gemeinsam, daß diese Grabenauffüllung sehr kritisch von der exakten Grabenform und darüber hinaus noch von dem Schichtabscheideverfahren abhängt. Ein besonderes Problem bildet dabei die Tendenz der CVD-Verfahren, durch eine höhere Abscheiderate an den oberen Grabenkanten die sich von beiden Seiten nähernden Schichtoberflächen schließlich zusammentreffen zu lassen, ohne daß der untere Bereich des Grabens durch eine Schicht entsprechender Dicke völlig gefüllt wird. Darüber hinaus ist es zur Erzielung der angestrebt planen Oberfläche nötig, den Schichtabscheideprozeß auch nach Schließung des Grabens weiterzuführen, um die vom Graben herrührende Vertiefung auszugleichen.

Zur Vermeidung dieser zeitintensiven weiteren Abscheidung ist vorgeschlagen worden, nach Füllung der tiefen Spalte die noch vorhandenen Unebenheiten durch Photolacke (wie in IBM Technol. Discl. Bull. Vol. 25-5, 10.82, Seiten 2292 bis 2293, vorgeschlagen) oder ein Fließglas (siehe Europäische Patentanmeldung Nr. 0 055 521 A1 und 0 098 687 A2) einzuebnen und dann die Rückätzung durchzuführen. Bei Erreichung der ursprünglichen Grabenoberkante tritt jedoch in jedem Falle das Problem auf, daß die CVD-Schicht an der Naht des Zusammenwachsens eine höhere Ätzrate zeigt. Es besteht so die Gefahr, daß dort doch wieder eine stärkere Vertiefung ausgeätzt wird bzw. daß sogar eine Durchätzung bis zu dem im unteren Grabenteil zurückgebliebenen Hohlraum erfolgt, die aus Gründen der weiteren Prozessierbarkeit nicht tolerabel ist. Darüber hinaus besteht je nach Material der CVD-Auffüllschicht bei späteren Hochtemperaturprozeßschritten die Gefahr, daß durch die unterschiedlichen thermischen Ausdehnungskoeffizienten der Grabenfüllung und des Substrats vom Graben ausgehend Kristallfehler erzeugt werden.

Bei einem anderen Verfahren (siehe IBM Technol. Discl. Bull. Vol. 25-4, 9.82, Seiten 1890 bis 1891), welches auf der Zuoxidation des Grabens beruht, ist ebenfalls die gewünschte plane Oberfläche nicht erzielbar und es werden starke Spannungen im Substrat erzeugt.

Die Verwendung eines Spin-on-Glases, wie es im IBM Technol. Discl. Bull. 25-8, 1.83, Seiten 4410 bis 4411, beschrieben ist, erscheint zur Auffüllung tiefer Gräben ebenfalls ungeeignet, da dieses Glas bei späteren Hochtemperaturschritten einen extrem starken Schwund seines Volumens erleidet, wodurch ebenfalls Spannungen und Hohlräume erzeugt werden können.

Der Vorschlag, mit einem Phosphorsilikatglas - (PSG) den Graben teilweise auszukleiden und anschließend zuzufließen (siehe Europäische Pat. Anm. Nr. 0 041 716 A2), ist wegen der schlechten Fließeigenschaften des PSG allenfalls durch die Kombination von hoher Phosphordotierung der Schicht und einem sehr effektiven Verfließschritt möglich, für den dementsprechend ein Laserstrahl benötigt wird.

Aufgabe der Erfindung ist es deshalb, ein Auffüllverfahren zur Grabenisolation anzugeben, mit dem auch extrem tiefe Gräben, wie sie in der Sub μm-Isolation von MOS-und Bipolarschaltungen erforderlich sind, ohne Bildung von Spannungen, Hohlräumen oder Ätzinhomogenitäten aufgefüllt werden können und mit dem nach einer oder zwei Standardofen-Verfliessungen eine plane Oberfläche erzielt werden kann.

Diese Aufgabe wird bei einem Verfahren der eingangs genannten Art dadurch gelöst, daß

a) für die SiO₂-Abscheidung Tetraethylorthosilikat mit Trimethylborat und Phosphin mit Sauerstoff gleichzeitig thermisch zersetzt wird,

b) die thermische Zersetzung der Verbindungen im Temperaturbereich zwischen 600 und 700°C in einem Niederdruck-Reaktor durchgeführt wird und

c) nach dem Verfließenlassen der aus Bor-Phosphor-Silikatglas bestehenden Schicht bei Temperaturen kleiner 900°C die auf der Substratoberfläche befindliche Bor-Phosphor-Silikatglasschicht durch Rückätzung entfernt wird.

Die Verwendung der Oxidabscheidung auf der Basis Tetraethylorthosilikat für Isolationszwischenschichten im Bereich von Mehrlagenverdrahtungen in integrierten Halbleiterschaltungen ist bereits auf dem ECS Fall Meeting 1985 vorgetragen worden und aus dem Extr. Abstr. Vol. 85-2, 10.85, Nr. 254, zu entnehmen.

In einer Weiterbildung des Erfindungsgedankens ist vorgesehen, die Temperatur bei der thermischen Zersetzung zwischen 630 und 680°C und den Druck auf Werte kleiner 133.32 Pa, vorzugsweise im Bereich zwischen 15 und 100 Pa einzustellen. Bei Verwendung von Phosphin empfiehlt sich Sauerstoff beizumischen, wobei das Phosphin/Sauerstoff-Verhältnis kleiner 0,2 beträgt.

Weitere Ausgestaltungen der Erfindung ergeben sich aus den Unteransprüchen.

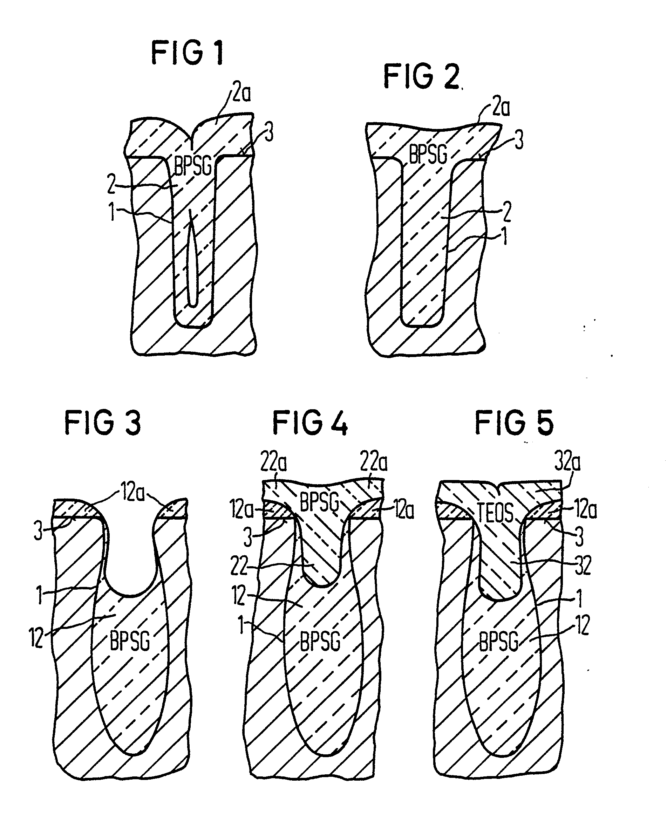

Anhand von Ausführungsbeispielen und der Figuren 1 bis 5 soll im folgenden die Erfindung noch näher erläutert werden. Die Figuren stellen im Schnittbild in ein Siliziumsubstrat (3) geätzte Gräben 1 dar, die gemäß der Lehre der Erfindung mit Bor-Phosphor-Silikatglas 2 (BPSG) aufgefüllt werden.

Figur 1 zeigt einen mit BPSG 2 fast vollständig gefüllten Graben 1, wobei die Dicke der Füllschicht 2 so gewählt wird, daß sie mindestens 60 % der Breite des Grabens 1 entspricht.

Durch Wahl des Borgehaltes größer 5 Gewichtsprozent und des Phosphorgehaltes von ca. 3 Gewichtsprozent läßt sich der Erweichungspunkt des Glases so einstellen, daß schon Verfließtemperaturen kleiner 900°C zur hohlraumfreien Zufließung des Grabens 1 ausreichend sind, wie es aus der Figur 2 ersichtlich ist. In einem anschließenden Rückätzschritt wird das auf der Substratoberfläche 3 befindliche überschüssige Bor-Phosphor-Silikatglas 2a rückgeätzt.

Figur 3: Ist aufgrund der Form des Grabens 1 (extreme Tiefe, "Tonnenform") eine hohlraumfreie Zufließung trotz der guten Fließeigenschaften und der den anderen Verfahren überlegenen Kantenbedeckung des aus Tetraethylorthosilikat plus Trimethylborat plus Phosphin/O₂ gebildeten Bor-Phosphor-Silikatglas (= TEOS BPSG) nicht möglich, dann wird in den Graben 1 eine hoch - (größer 5 %) mit Bor dotierte BPSG-Schicht 12 in einer Dicke kleiner 0,5 Gra benbreite abgeschieden und diese dann verflossen, wobei eine teilweise Auffüllung des Grabens 1 erzielt wird.

Figur 4: Durch entsprechend modifizierte Wiederholung des Prozesses (Abscheidung einer weiteren BPSG-Schicht 22 und Verfließung) wird die restliche Auffüllung und Planarisierung des Grabens 1 erreicht. Die auf der Substratoberfläche 3 befindlichen Restschichten 12a, 22a werden in gleicher Weise entfernt wie bei Figur 2 beschrieben.

Figur 5: Bei der Auffüllung kann auch die Kombination beider Schritte so gewählt werden, daß durch den ersten Schritt (Schicht 12, 12a) der Graben bereits soweit mit BPSG aufgefüllt ist, daß als zweite Schicht 32 eine undotierte Abscheidung zum Beispiel durch Abscheidung aus Tetraethylorthosilikat (TEOS) bei 730°C ausreichend ist. Die Rückätzung der aufgebrachten BPSG 12a und der SiO₂ -Schicht 32a bis zur Grabenoberkante 3 erfolgt dann zweckmäßigerweise durch Magnetronionenätzen, da bei diesen Verfahren eine gleiche Ätzrate für Bor-Phosphor-dotiertes (12a) und undotiertes SiO₂ (32a) erzielt werden kann. Dieses Verfahren kommt besonders dann zur Anwendung, wenn eine Ausdiffusion von Bor oder Phosphor aus dem oberen Bereich des Grabenauffülloxids in die darüberliegende Schicht (zum Beispiel Polysilizium) bei einem nachfolgenden Hochtemperaturschritt unerwünscht wäre.

Unter diesem Aspekt ist es selbstverständlich auch möglich, den oberen Teil des Grabens 1 mit nur Bor oder Phosphor enthaltendem TEOS-Oxid aufzufüllen. Ist eine Dotierung der Grabenwände (1) durch das abgeschiedene SiO₂ nicht erwünscht, so wird der Graben 1 vorher mit einem zum Beispiel thermisch gewachsenen oder CVD-abgeschiedenen undotierten Oxid ausgekleidet (nicht abgebildet). Ist dagegen eine Bor-oder Phosphordotierung der Grabenwände erwünscht, so wird der Graben mit der entsprechenden, nur Bor bzw. Phosphor enthaltenden TEOS Oxidschicht ausgekleidet, bevor die BPSG-Abscheidung erfolgt. Im Falle der Bordotierung kann wegen des höheren Diffusionskoeffizienten von Phosphor in Silizium und $SiO_2$ eine undotierte $SiO_2$ -Schicht zwischen BPSG und BSG eingesetzt werden (ebenfalls nicht dargestellt).

Alle diese Schichten (2, 12, 22, 32) können in der gleichen Anlage hergestellt werden. Die oben beschriebenen Varianten gelten sinngemäß auch für den Einsatz von Arsensilikatglas (ASG), welches auch durch die Reaktion von TEOS mit organischen Arsenverbindungen wie zum Beispiel Triäthoxyarsin $(C_2H_5O)_3As$ anstelle von Phosphorverbindungen hergestellt werden kann.

Das erfindungsgemäße Verfahren (mit dotiertem TEOS-Oxid) hat vor bekannten Isolationstechniken den großen Vorteil, daß mit diesem Material geringere Spannungen im Substrat zu erwarten sind.

Bezugszeichenliste

1 = Graben im Substrat
2 = Bor-Phosphor-Silikat-Glas
2a = Bor-Phosphor-Silikat-Glas
3 = Substratoberfläche
12 = Bor-Phosphor-Silikat-Glas
12a = Bor-Phosphor-Silikat-Glas
22 = Bor-Phosphor-Silikat-Glas
22a = Bor-Phosphor-Silikat-Glas
32 = $SiO_2$-Schicht
32a = $SiO_2$-Schicht

**Ansprüche**

1. Verfahren zur Auffüllung von in Siliziumsubstrate (3) zum Zwecke der Isolation der aktiven Bauelemente einer integrierten Schaltung eingebrachten Gräben (1) mit im wesentlichen aus $SiO_2$ bestehendem Isolationsmaterial (2), **dadurch gekennzeichnet ,**
daß
a) für die $SiO_2$-Abscheidung (2) Tetraethylorthosilikat mit Trimethylborat und Phosphin mit Sauerstoff gleichzeitig thermisch zersetzt wird,
b) die thermische Zersetzung der Verbindungen im Temperaturbereich zwischen 600 und 700°C in einem Niederdruck-Reaktor durchgeführt wird und
c) nach dem Verfließenlassen der aus Bor-Phosphor-Silikatglas bestehenden Schicht (2) bei Temperaturen kleiner 900°C die auf der Substratoberfläche (3) befindliche BorPhosphor-Silikatglasschicht (2a) durch Rückätzung entfernt wird.

2. Verfahren nach Anspruch 1, **dadurch gekennzeichnet ,** daß die Temperatur bei der thermischen Zersetzung zwischen 630 bis 680°C und der Druck auf Werte kleiner 133,32 Pa eingestellt wird.

3. Verfahren nach Anspruch 1 und/oder 2, **dadurch gekennzeichnet,** daß der Phosphinverbindung Sauerstoff beigemischt wird, wobei das Phosphin/-Sauerstoff-Verhältnis kleiner 0,2 beträgt.

4. Verfahren nach Anspruch 1, **dadurch gekennzeichnet,** daß anstelle von Phosphin Trimethylphosphat verwendet wird.

5. Verfahren nach mindestens einem der Ansprüche 1 bis 4, **dadurch gekennzeichnet,** daß der Druck im Reaktor auf einen Bereich zwischen 15 bis 100 Pa eingestellt wird.

6. Verfahren nach mindestens einem der Ansprüche 1 bis 5, **dadurch gekennzeichnet,** daß die Schichtdicke der zur Auffüllung vorgesehenen Bor-Phosphor-Silikatglasschicht (2) auf mindestens 60 % der vorhandenen Grabenbreite (1) eingestellt wird.

7. Verfahren nach mindestens einem der Ansprüche 1 bis 6, **dadurch gekennzeichnet,** daß der Borgehalt auf mindestens 5 Gew.-% und der Phosphorgehalt auf einen Wert im Bereich von 3 Gew.-% eingestellt wird.

8. Verfahren nach mindestens einem der Ansprüche 1 bis 7, **dadurch gekennzeichnet,** daß die Abscheidung (12, 22, 32) in mehreren Stufen durchgeführt wird, wobei zunächst eine mit Bor größer als 5 Gew.-% dotierte Schicht (12) in einer Dicke von maximal der halben Grabenbreite abgeschieden wird, dann ein Verfließprozeß durchgeführt wird und anschließend der Abscheidungs - (22)-und Verfließprozeß solange wiederholt wird, bis die Auffüllung beendet ist.

9. Verfahren nach Anspruch 8, **dadurch gekennzeichnet,** daß im letzten Abscheidungsprozeß eine undotierte $SiO_2$-Schicht (32) aufgebracht wird.

10. Verfahren nach mindestens einem der Ansprüche 1 bis 9, **dadurch gekennzeichnet ,** daß die Rückätzung durch Magnetron-Ionenätzen erfolgt.

11. Verfahren nach mindestens einem der Ansprüche 1 bis 10, **dadurch gekennzeichnet,** daß vor der Erzeugung der zur Auffüllung vorgesehenen Bor-Phosphor-Silikatglasschicht (2, 12, 22) eine Auskleidung der Grabenwände (1) mit undotiertem $SiO_2$ durch thermische Oxidation oder durch thermische Zersetzung einer Silizium und Sauerstoff enthaltenden gasförmigen Verbindung durchgeführt wird.

12. Verfahren nach mindestens einem der Ansprüche 1 bis 10, **dadurch gekennzeichnet,** daß vor der Erzeugung der zur Auffüllung vorgesehenen Bor-Phosphor-Silikatglasschicht (2, 12, 22) eine Auskleidung der Grabenwände (1) mit einer nur Bor oder einer Phosphor dotierten SiO₂Schicht durch thermische Zersetzung von Tetraethylorthosilikat und Trimethylborat bzw. Phosphin oder Trimethylphosphat durchgeführt wird.

13. Verfahren nach Anspruch 12, **dadurch gekennzeichnet,** daß zwischen der mit Bor dotierten SiO₂-Schicht und der Bor-Phosphor-Silikatglasschicht (2, 12, 22) eine undotierte SiO₂-Schicht abgeschieden wird.

14. Verfahren nach mindestens einem der Ansprüche 1 bis 13, **dadurch gekennzeichnet,** daß anstelle von Phosphin oder Trimethylphosphat eine organische Arsenverbindung wie beispielsweise Triäthoxyarsin verwendet wird.

# FIG 1

2a
3
BPSG
2
1

# FIG 2.

2a
3
BPSG
2
1

# FIG 3

12a
3
1
12
BPSG

# FIG 4

22a        22a
BPSG
12a              12a
3
22
12
1
BPSG

# FIG 5

32a
12a
TEOS
3
32
1
12
BPSG

Europäisches Patentamt

# EUROPÄISCHER RECHERCHENBERICHT

Nummer der Anmeldung

EP .87 10 0617

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | EXTENDED ABSTRACTS OF THE JOURNAL OF THE ELECTROCHEMICAL SOCIETY, Band 85-2, 1985, Seiten 380-381, Zusammenfassung Nr. 254, Princeton; F.S. BECKER et al.: "A new LPCVD borophosphosilicate glass process based on the doped deposition of TEOS-oxide" * Seite 380; Figur 3 * | 1-14 | H 01 L 21/76 H 01 L 21/316 |
| | --- | | |
| A | PATENT ABSTRACTS OF JAPAN, Band 10, Nr. 150 (E-408)[2207], 31. Mai 1986; & JP-A-61 8945 (NIPPON DENKI K.K.) 16-01-1986 | 1 | |
| | --- | | |
| A | PATENT ABSTRACTS OF JAPAN, Band 9, Nr. 136, 12. Juni 1984, Seite 1859; & JP-A-60 20530 (NIPPON DENKI K.K.) 01.02.1985 | 1 | RECHERCHIERTE SACHGEBIETE (Int. Cl.4) |
| | --- | | H 01 L |
| A | EP-A-0 141 496 (MORTON THIOKOL, INC.) * Seite 1, Zeilen 8-13; Seite 2, Zeilen 1-27; Patentansprüche 1,2,6-8 * | 1,2,4, 14 | |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 28-04-1987 | VANCRAEYNEST F.H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82